# FASCICULE DE BREVET EUROPEEN

(11) **EP 0 343 698 B1**
(45) Date de publication et mention de la délivrance du brevet: **20.07.1994**
(21) Numéro de dépôt: 89200972.1
(22) Date de dépôt: 17.04.1989
(51) Int. Cl.: H01L 21/90, C23F 4/00

(54) **Procédé pour réaliser une configuration d'interconnexion sur un dispositif semiconducteur notamment un circuit à densité d'intégration élevée**
Herstellungsverfahren für Verbindungsstrukturen auf einem Halbleiterbauelement, besonders auf einem hochintegrierten Schaltkreis
Process for producing interconnect structures on a semiconductor device, especially on an LSI circuit

(30) Priorité: 22.04.1988 FR 8805391
(43) Date de publication de la demande: 29.11.1989
(73) Titulaire: Philips Electronics N.V., 5621 BA Eindhoven (NL)
(72) Inventeur: Grief, Malcolm, NL-5656 AA Eindhoven (NL); Doan, Trung, NL-5656 AA Eindhoven (NL); Van Houtun, Hendrikus, NL-5656 AA Eindhoven (NL); Van Laarhoven, Josephus, NL-5656 AA Eindhoven (NL)
(74) Mandataire: Pinchon, Pierre

(56) Documents cités:
- WO-A-87/04858
- IBM TECHNICAL DISCLOSURE BULLETIN, vol. 29, no. 9, février 1987, pages 3925-3927, New York, US; "Contact via definition where quartz insulation of metal lines is required"
- 1987 PROCEEDINGS FOURTH INTERNATIONAL IEEE VLSI MULTILEVEL INTERCONNECTION CONFERENCE, 15-16 juin 1987, Santa Clara, CA, pages 292-297, IEEE; R.W. WU et al.: "A reliable LPCVD tungsten interconnection process utilizing polyimide/plasma nitride as an interlayer dielectric"
- 1986 PROCEEDINGS THIRD INTERNATIONAL IEEE VLSI MULTILEVEL INTERCONNECTION CONFERENCE, Santa Clara, CA, 9-10 juin 1986, pages 403-410, IEEE; G.C. SMITH et al: "Comparison of two contact plug techniques for use with planarized oxide"
- IBM TECHNICAL DISCLOSURE BULLETIN, vol. 24, no. 10, mars 1982, pages 5133-5134, New York, US; S. BOYAR et al.: "Quartz trench rie etch stop"
- 1987 PROCEEDINGS FOURTH INTERNATIONAL IEEE VLSI MULTILEVEL INTERCONNECTION CONFERENCE, Santa Clara, CA, 15-16 juin 1987, pages 193-199, IEEE; J.-J. LEE et al.: "A study of tungsten etchback for contact and via fill applications"

## Description

La présente invention concerne un procédé pour réaliser une configuration d'interconnexion sur un dispositif semiconducteur, notamment un circuit intégré, procédé qui comporte les étapes consistant :
- à former une couche isolante sur un substrat sur lequel sont élaborés les éléments du dispositif,
- à graver des ouvertures de contact étroites dans cette couche isolante,
- à déposer au moins une couche de matériau conducteur selon une méthode assurant un bon recouvrement de surface, y compris de la surface intérieure des ouvertures de contact, couche dont l'épaisseur totale est suffisante pour remplir le volume des ouvertures de contact,
- à retirer par décapage la majeure partie du matériau conducteur pour conserver ce matériau uniquement dans les ouvertures de contact,
- à déposer une couche métallique d'interconnexion et à la graver à la forme de la configuration désirée.

La technologie des semiconducteurs montre une évolution constante en faveur d'une intégration de plus en plus élevée du nombre de composants élémentaires dans un même circuit monolithique.

Dans ce but ainsi qu'en vue d'augmenter la rapidité de fonctionnement des circuits, on est amené à réduire le plus possible les dimensions des composants élémentaires. Les techniques classiques de prise de contact sur les dispositifs semiconducteurs utilisaient, jusqu'à une époque récente, des zones de contact et des lignes d'interconnexion dont les dimensions latérales étaient le plus souvent beaucoup plus grandes que l'épaisseur de la couche métallique constituant lesdites lignes. En ce qui concerne la réalisation de circuits à haute densité d'intégration il est au contraire nécessaire de prévoir des ouvertures de contact dont le diamètre soit du même ordre de grandeur que l'épaisseur de la couche isolante dans laquelle ces ouvertures de contact sont pratiquées. A ce propos, on se réfère fréquemment au rapport entre la profondeur et le diamètre des ouvertures de contact, appelé rapport d'aspect, qui lorsque ce rapport est voisin de l'unité ou même supérieur, indique que les techniques antérieures de prise de contact basées notamment sur le simple dépôt d'une couche d'aluminium ne peuvent plus être utilisées avec succès.

C'est ainsi que le procédé cité dans le paragraphe introductif a été proposé pour fournir une solution convenant pour la réalisation d'une configuration d'interconnexion sur un circuit à haute densité d'intégration, dans lequel les ouvertures de contact ont un rapport d'aspect voisin ou supérieur à l'unité.

Un procédé de ce type est connu du document EP-A-0 165 085. Parmi les matériaux conducteurs préconisés pour le remplissage des ouvertures de contact, le titane et le tungstène sont mentionnés. Il est connu par ailleurs (du document IBM Techn.Discl.Bulletin, Vol 29, No 9, Fév. 1987, p 3925-3926), qu'une solution particulièrement intéressante du point de vue des performances : faible résistance électrique et bonne tenue mécanique notamment, consiste à utiliser d'abord une mince couche d'alliage titane-tungstène comme couche d'adhésion et de recouvrement de toute la surface, puis une couche épaisse de tungstène pour le remplissage effectif des ouvertures de contact.

La méthode généralement utilisée pour déposer la couche de tungstène de remplissage des ouvertures de contact est celle connue sous le nom de dépôt chimique en phase vapeur sous pression réduite (LPCVD).

Cette méthode en effet assure un bon recouvrement de toute la surface, à partir de la couche d'alliage Ti-W qui sert à activer la nucléation de dépôt du tungstène. Le remplissage des ouvertures de contact est obtenu lorsque l'épaisseur de la couche déposée est au moins égale à la moitié du diamètre de ces ouvertures.

Selon ce procédé, après le décapage de la couche de tungstène réalisé en vue de ne conserver de celle-ci que les portions contenues à l'intérieur des ouvertures de contact, on observe que la surface supérieure de la couche isolante ainsi libérée présente fréquemment une rugosité plus ou moins prononcée et qui peut être distribuée irrégulièrement sur le substrat.

Cette dégradation de la planéité de surface de la couche isolante semble liée à la formation de microcristaux dans la couche de matériau conducteur servant au remplissage des ouvertures de contact. En effet, cette couche est nécessairement assez épaisse et est donc obtenue dans des conditions qui favorisent une vitesse de dépôt relativement élevée de manière à ce que le procédé reste économique.

Lors du décapage du matériau conducteur, il est fréquent en pratique, que l'attaque utilisée ne soit pas sélective par rapport au matériau de la couche isolante et qu'on soit donc amené à attaquer une fraction superficielle de cette couche isolante pour garantir l'élimination complète du matériau conducteur partout ailleurs que dans les ouvertures de contact.

La rugosité de surface se trouve alors reportée sur la couche isolante.

La poursuite du processus de fabrication du dispositif semiconducteur se trouve gravement perturbée par l'apparition de ce défaut. En effet, la rugosité de surface de la couche isolante influence la cristalisation de la couche métallique d'interconnexion, habituellement en un alliage d'aluminium, qui la recouvre ultérieurement et aboutit notamment à une réduction de la résistance à l'électromigration de cette couche métallique.

D'autre part, la rugosité est également reproduite à son tour sur la surface de la couche métallique et provoque, lors de l'opération de photomasquage de cette couche, une dégradation très importante de la définition optique du masque de laque. La gravure localisée de la couche métallique se trouve ainsi gravement perturbée.

Ainsi, l'invention vise-t-elle à fournir un perfectionnement au procédé indiqué, tel que les difficultés mentionnées ci-dessus sont évitées.

En effet, selon la présente invention, un procédé pour réaliser une configuration d'interconnexion sur un dispositif semiconducteur, notamment un circuit intégré, comporte les étapes énoncées à la revendication 1.

Comme la couche de séparation est éliminée sélectivement par rapport à la couche isolante, aucune irrégularité de surface éventuellement portée par la couche de séparation ne peut être transmise par décapage à la surface de la couche isolante laquelle conserve son état plan d'origine.

Selon un mode avantageux de mise en oeuvre de l'invention, la couche de séparation est choisie pour pouvoir être éliminée sélectivement par rapport au matériau conducteur de remplissage. Ainsi, par la valeur de l'épaisseur donnée à la couche de séparation, on dispose d'un paramètre permettant après le retrait de la majeure partie du matériau conducteur, d'ajuster le niveau supérieur des portions restantes de ce matériau dans les ouvertures de contact, par rapport au niveau de la surface de la couche isolante. Il a été observé en effet que la qualité et la régularité des contacts obtenu par le procédé mentionné dépendait pour une part importante du fait que le niveau des portions de matériau conducteur ne soit pas inférieur au niveau de la couche isolante avoisinante, et que ces portions de matériau conducteur forment au contraire une protubérance de valeur contrôlée qui facilite un contact à faible résistance avec la couche métallique qui les recouvre ultérieurement.

Selon un premier mode de mise en oeuvre détaillé de l'invention, le procédé est caractérisé en ce que la couche isolante est formée par un verre de silice, le matériau de remplissage par du tungstène ou un alliage riche en tungstène, et la couche de séparation est réalisée en nitrure de silicium.

Dans ce cas, il y a lieu de tenir compte, dans le choix de l'épaisseur de la couche de séparation, de la fraction superficielle de cette couche qui sera éliminée à la suite du décapage de la couche de tungstène, lorsqu'on prolonge quelque peu cette attaque pour tenir compte des légères dispersions opératoires qui sont pratiquement inévitables.

La sélectivité de décapage du nitrure de silicium par rapport au verre de silice permet une élimination de la couche de séparation qui laisse la surface de la couche isolante dans son état original c'est-à-dire exempt de rugosité.

Selon un deuxième mode de mise en oeuvre de l'invention, le procédé est caractérisé en ce que la couche de séparation est choisie d'une nature telle que le matériau conducteur de remplissage puisse être décapé sélectivement par rapport à la couche de séparation, laquelle est utilisée lors du décapage du matériau conducteur à l'étape e du procédé, comme couche d'arrêt de décapage.

Selon ce mode de mise en oeuvre, la couche de séparation n'est pratiquement pas consommée à l'issue de l'élimination du matériau conducteur et l'élimination de la rugosité de surface est obtenue dès ce stade du procédé.

Selon une variante avantageuse de ce deuxième mode de mise en oeuvre, lors de la gravure des ouvertures de contact, on met en oeuvre la sélectivité de décapage de la couche de séparation qui est utilisée en tant que masque additionnel pour la gravure de la couche isolante. Comme il s'agit précisément d'obtenir des ouvertures de contact ayant un rapport d'aspect élevé pour lesquelles on désire obtenir des parois d'ouvertures pratiquement verticales, on peut choisir des conditions d'attaque anisotropique avantageuses où la couche de séparation joue le rôle d'un masque plus résistant que le masque de résine photosensible initialement utilisé pour la définition des ouvertures dans la couche de séparation.

Selon un mode de réalisation préféré du deuxième mode de mise en oeuvre de l'invention, le procédé est caractérisé en ce que le matériau conducteur de remplissage étant formé par du tungstène ou un alliage riche en tungstène, la couche de séparation est réalisée en l'un des métaux tels que l'aluminium, un alliage d'aluminium, ou le cobalt.

La description qui va suivre en regard des dessins annexés, donnés à titre d'exemples non limitatifs, fera bien comprendre comment l'invention peut être réalisée.
Les figures 1, 2, 3A, 4A et 5A représentent des vues schématiques, en coupe, d'une partie d'un dispositif semiconducteur à différentes étapes successives du procédé selon l'invention selon un premier exemple de réalisation et,
les figures 3B, 4B et 5B des vues similaires respectivement aux figures 3A, 4A et 5A, mais selon un deuxième exemple de réalisation.

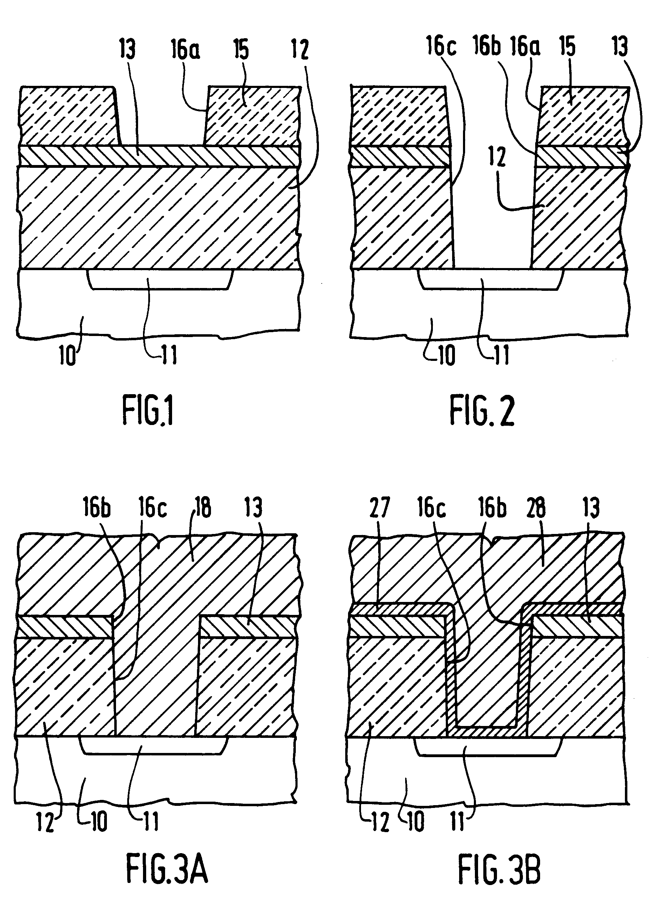

Le procédé selon l'invention concerne la réalisation d'une configuration d'interconnexions sur un dispositif semiconducteur dont une portion a été représentée schématiquement à la figure 1.

Dans un substrat 10 en silicium par exemple, ont été élaborés les différents éléments actifs d'un circuit intégré, les différentes étapes du procédé qui sera décrit ayant pour but de prendre un contact électrique avec une région active 11 du dispositif qui peut être par exemple une région de source ou de drain d'un transistor à effet de champ de type MOS. Sur le substrat 10 on a formé une couche isolante 12 réalisée le plus souvent en verre de silice éventuellement dopé au phosphore ou au bore.

Pour assurer un isolement convenable de la configuration d'interconnexions qui sera ultérieurement portée par la couche isolante 12 et en vue de réduire le plus possible les capacités parasites de cette configuration par rapport au substrat, la couche isolante 12 présente une épaisseur relativement importante de l'ordre de 0,8 à 1»m.

Conformément au procédé selon l'invention on recouvre la couche isolante 12 une couche dite de séparation 13 d'une nature telle qu'elle puisse être décapée sélectivement par rapport à la couche isolante 12. Selon le matériau choisi pour constituer la couche de séparation 13, l'épaisseur de cette couche peut varier mais néanmoins elle est généralement comprises entre 50 nm et 300 nm. L'ensemble du dispositif a été ensuite recouvert d'un masque 15 de laque photosensible dans lequel on a créé des ouvertures 16a aux emplacements où des contacts doivent être créés.

Comme cela est représenté à la figure 2, à l'aide du masque 15, on a gravé successivement une ouverture 16b dans la couche de séparation 13 et une ouverture 16c dans la couche isolante 12, l'ouverture 16c ayant une profondeur telle que la surface de la région active 11 soit découverte. Afin de limiter au maximum l'encombrement des éléments du dispositif intégré, le diamètre des ouvertures de contact telles que 16c est par exemple de 0,8 »m, de sorte que ces ouvertures ont un rapport d'aspect égal ou légérement supérieur à 1. De manière à obtenir des ouvertures de contact 16c dont les parois soient pratiquement verticales on utilise un procédé de gravure anisotropique connu sous le nom de décapage par ions réactifs. La gravure de l'ouverture 16b dans la couche de séparation 13, quant à elle, fait appel à une technique de décapage directement liée à la nature du matériau choisi pour former cette couche et pour laquelle plus de détails seront donnés ci-après.

Il est à noter toutefois que la couche de séparation 13 a une épaisseur telle que l'ouverture 16b qui y est pratiquée a un rapport d'aspect très inférieur à 1 et qu'en conséquence, la question de l'angle des parois de cette ouverture 16b ne présente pas une importance aussi grande que pour l'ouverture 16c dans la couche isolante 12.

On se reporte maintenant à la figure 3A correspondant à l'étape du procédé dans laquelle on a déposé une couche de matériau conducteur 18 suffisamment épaisse pour que l'ouverture de contact 16b, 16c soit entièrement remplie de ce matériau conducteur. On utilise pour cela une méthode connue pour fournir un bon recouvrement de surface y compris des surfaces qui sont intérieures aux ouvertures de contact. Parmi ces méthodes connues figure la méthode dite de dépôt chimique en phase vapeur, à pression réduite (LPCVD) ou encore à pression atmosphérique (CVD). On peut choisir en tant que matériau conducteur 18 du tungstène, un alliage de tungstène et de titane, un alliage de tungstène et de silicium, ou du silicium polycristallin fortement dopé pour être suffisamment conducteur.

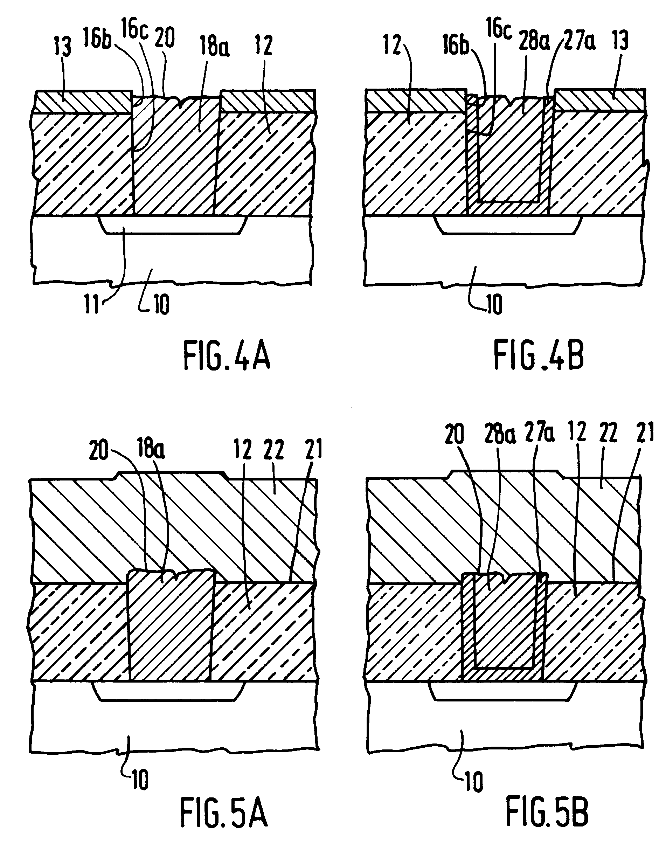

L'opération suivante, consistant à retirer par décapage la majeure partie du matériau conducteur 18 est illustrée à la figure 4A. Le décapage du matériau conducteur 18 est de préférence effectué dans un plasma dont la nature dépend de la nature du matériau conducteur utilisé. Dans le cas du tungstène ou d'un alliage riche en tungstène, on utilisera par exemple un plasma d'hexafluorure de soufre (SF₆). Comme on cherche à libérer entièrement la surface de la couche de séparation 13 pour ne conserver que des éléments 18a du matériau conducteur localisés à l'intérieur des ouvertures de contact 16c, il est nécessaire de prolonger quelque peu l'attaque pour tenir compte des dispersions possibles dans l'épaisseur du matériau conducteur 18 ou de légères variations dans les conditions opératoires. Selon la nature de la couche de séparation 13 et de sa plus ou moins grande résistance à cette attaque, le niveau de l'élément 18a de matériau conducteur peut donc se situer quelque peu en dessous du niveau de la couche de séparation 13 à l'issue de l'opération de décapage. L'arrêt de l'attaque est défini soit par un contrôle précis de la durée de gravure, soit par un moyen de détection quelconque notamment utilisant la variation d'intensité d'une raie particulière d'émission du plasma.

L'opération suivante consistant en l'élimination de la couche de séparation 13 est faite sélectivement par rapport à la couche isolante 12. En conséquence la surface de la couche isolante 12, ainsi libérée, est exempte de toute irrégularité indépendamment de la rugosité possible de la surface de la couche de séparation 13. Avantageusement on aura choisi le matériau de la couche de séparation 13 de telle sorte qu'il puisse être éliminé sélectivement par rapport au matériau conducteur 18. Ainsi, comme illustré à la figure 5A le niveau supérieur 20 de l'élément 18a de matériau conducteur peut être rendu plus élevé, si on le désire, par rapport au niveau 21 de la surface de la couche isolante 12.
Un tel décalage est procuré par différence en raison de l'épaisseur de la couche de séparation 13 qui est éliminée.

Selon un premier mode pratique de mise en oeuvre de l'invention, la couche de séparation 13 est réalisée en nitrure de silicium (Si₃N₄). A la fin de l'attaque de la couche de matériau conducteur 18, la couche de séparation 13 ne constitue pas une barrière de décapage mais est au contraire attaquée à une vitesse qui est du même ordre de grandeur que la vitesse d'attaque du matériau conducteur 18 dans le cas où celui-ci est du tungstène ou un alliage riche en tungstène. Il y a lieu de prévoir une épaisseur de la couche de séparation 13, qui soit en rapport avec la durée durant laquelle on prolonge le décapage de la couche de matériau conducteur 18 puisqu'une une portion superficielle de la couche de séparation 13 sera décapée durant cette phase de prolongation du décapage. A titre d'exemple une épaisseur de 150 à 300 nm pour la couche de séparation 13 en Si₃N₄ s'est avérée convenable. Comme le nitrure de silicium peut être décapé sélectivement à la fois par rapport à du verre de silice et à la fois par rapport à du tungstène en utilisant la méthode d'attaque humide dans de l'acide phosphorique chaud, on utilise une telle méthode pour retirer la couche de séparation 13 et provoquer ainsi la différence de niveau observée sur la figure 5A entre le sommet 20 de l'élément 18a de matériau conducteur de remplissage de l'ouverture de contact et le niveau 21 de la couche isolante 12. En jouant d'une part sur le temps de prolongation du décapage de la couche de matériau conducteur 18 et d'autre part sur l'épaisseur de la couche de séparation 13, il est facile d'obtenir que le niveau 20 de l'élément 18a de matériau conducteur de remplissage soit au même niveau que la surface 21 de la couche isolante 12 ou qu'il le dépasse d'une faible hauteur déterminée. Il a été observé en effet que dans ces conditions, on obtient les meilleurs résultats en ce qui concerne la résistance de contact entre les éléments 18a de matériau conducteur de remplissage et la couche métallique d'interconnexion 22 qui est déposée ultérieurement sur la structure.

La couche métallique 22 est réalisée par exemple en aluminium ou en alliage d'aluminium-silicium et/ou aluminium-cuivre avec une épaisseur voisine de 1»m, couche dans laquelle la configuration d'interconnexion est réalisée par les méthodes de photomasquage et de gravure habituelles.

Selon un autre mode de mise en oeuvre de l'invention le matériau utilisé pour constituer la couche de séparation 13 est d'une nature telle que le matériau conducteur 18 puisse être décapé sélectivement par rapport à cette couche de séparation 13. Dans ce cas on utilise de préférence de l'aluminium ou un alliage d'aluminium ou encore du cobalt. Dans l'étape du procédé consistant à retirer par décapage la majeure partie du matériau conducteur 18, la couche de séparation 13 constitue alors une couche d'arrêt à la fin de ce décapage. Lorsque l'on prolonge l'attaque du matériau conducteur 18, la couche de séparation 13 n'est pas attaquée c'est pourquoi, on peut lui donner une épaisseur légèrement plus faible que dans le mode de mise en oeuvre précédemment décrit. C'est ainsi qu'une épaisseur choisie entre 50 et 150 nm est tout à fait convenable. Lorsque la couche de séparation 13 est réalisée en aluminium ou en alliage d'aluminium elle peut être éliminée sélectivement par rapport à la couche isolante 12 et par rapport au matériau conducteur 18 de remplissage au moyen d'une gravure sèche utilisant un plasma riche en ions chlore. Elle peut également être réalisée par voie humide, dans une solution à base d'acide orthophosphorique couramment utilisée par les spécialistes du domaine.

Lorsque la couche de séparation 13 est en cobalt, pour éliminer sélectivement cette couche on utilise alors un décapage par voie humide, par exemple au moyen d'un mélange de trois parties d'HCl à 30% et d'une partie de H₂O₂, à température ambiante.

Selon un mode particulièrement avantageux de mise en oeuvre de l'invention la sélectivité de décapage de la couche de séparation 13 par rapport à la couche isolante 12 est mise à profit lors de la gravure des ouvertures de contact 16C. On peut choisir en effet des conditions de gravure dans la couche isolante 12 qui sont telles que la couche de séparation 13 n'est pas attaquée et sert ainsi de masque additionnel pour la gravure des ouvertures de contact 16c. Lorsque la couche de séparation 13 est en aluminium ou en cobalt et après avoir réalisé une ouverture 16b dans cette couche en utilisant un décapage approprié en présence du masque de laque photosensible 15 (voir figure 2), on procède à la gravure des ouvertures 16c à travers la couche isolante 12. Comme il a été indiqué précédemment cette gravure est de préférence effectuée par décapage d'ions réactifs riches en fluor. Dans cette opération, la couche de séparation 13 avec son ouverture 16b constitue un masque plus résistant à cette gravure que le masque de laque photosensible 15 lui-même. Ce dernier éventuellement peut être supprimé avant la gravure des ouvertures de contact mais il peut également être conservé. En utilisant une couche de séparation 13 comme masque additionnel pour la gravure des ouvertures de contact 16c dans la couche isolante 12, la gravure d'ouvertures de contact étroites et profondes se trouve facilitée ainsi que l'obtention de parois d'ouvertures pratiquement verticales.

La figure 3B illustre une variante de réalisation du procédé selon l'invention. Selon cette variante le remplissage des ouvertures de contact 16b, 16c, par un matériau conducteur est réalisé en déposant d'abord une mince couche d'alliage titane-tungstène comme couche d'adhésion et de recouvrement de toute la surface y compris la surface intérieure de l'ouverture de contact 16c, puis en effectuant le dépôt d'une couche épaisse de tungstène 28 qui procure le remplissage effectif des ouvertures de contact. Comme indiqué précédemment, la couche de tungstène 28 est réalisée par dépôt chimique en phase vapeur à pression réduite (LPCVD) tandis que la couche d'alliage titane-tungstène 27 est déposée par pulvérisation cathodique avec une épaisseur de l'ordre de 100 nm. D'autres matériaux peuvent également utilisés à cet effet notamment un alliage tungstène-silicium, du titane, du nitrure de titane, ou un siliciure de métal réfractaire.

La figure 4B, correspond à un stade ultérieur du procédé, équivalent à celui de la figure 4A et dans lequel les mêmes repères numériques désignent des éléments similaires.

La majeure partie du matériau conducteur de remplissage 28 ainsi que la couche d'accrochage 27 ont été éliminées de la surface de la couche de séparation 13 et il ne subsiste de ces matériaux qu'une portion 27A et 28A localisée dans les ouvertures de contact 16c. Le décapage de la couche d'adhérence 27 en alliage titane-tungstène est obtenu dans les mêmes conditions que le décapage du tungstène pur l'un faisant suite à l'autre au cours de la même opération de décapage par plasma. La couche de séparation 13 joue donc le même rôle que celui décrit précédemment à propos de la figure 4A.

La figure 5B illustre le stade ultérieur du procédé qui correspond à celui de la figure 5A dans laquelle la couche de séparation 13 a été éliminée tandis qu'une couche métallique d'interconnexion 22 surmonte la structure et est en contact avec l'élément localisé de matériaux conducteur 28a, 27a. Comme décrit précédemment la suppression de la couche de séparation 13 permet de réhausser le niveau 20 de l'élément 28a du matériau conducteur de remplissage par rapport au niveau 21 de la couche isolante 12. Dans la variante décrite à l'aide des figures 3B à 5B la couche de séparation 13 peut être formée de l'un des matériaux déjà évoqués précédemment c'est-à-dire de nitrure de silicium, d'aluminium, d'un alliage d'aluminium ou de cobalt.

Le procédé selon l'invention n'est pas limité à la fabrication d'une structure d'interconnexion sur un circuit intégré à transistor MOS, il vise plus généralement la prise des contacts sur toute sorte de dispositifs semiconducteurs lorsqu'on désire utiliser des zones de contact et des ouvertures de contact de très petites dimensions.

## Revendications

1. Procédé pour réaliser une configuration d'interconnexion sur un dispositif semiconducteur, notamment un circuit intégré, procédé comportant les étapes consistant :
a) à former une couche isolante (12) sur un substrat (10) sur lequel sont élaborés les éléments du dispositif,
b) à recouvrir la couche isolante (12) d'une couche (13) dite de séparation d'une nature telle qu'elle puisse être décapée sélectivement par rapport à la couche isolante (12),
c) à graver des ouvertures de contact (16b, 16c) étroites à travers la couche de séparation (13) et la couche isolante (12),
d) à déposer au moins une couche de matériau conducteur (18), (27, 28) selon une méthode assurant un bon recouvrement de surface, y compris de la surface intérieure des ouvertures de contact (16b, 16c), couche dont l'épaisseur totale est suffisante pour remplir le volume des ouvertures de contact,
e) à retirer par décapage la majeure partie du matériau conducteur (18), (27, 28) pour dégager la surface de la couche de séparation (13) mais pour conserver ce matériau (18a) (27a, 28a) dans les ouvertures de contact,
f) à éliminer sélectivement la couche de séparation (13),
g) à déposer une couche métallique d'interconnexion (22) et à la graver à la forme de la configuration désirée.

2. Procédé selon la revendication 1, caractérisé en ce que la couche de séparation (13) est choisie pour pouvoir être éliminée sélectivement par rapport au matériau conducteur de remplissage (18), (27, 28).

3. Procédé selon la revendication 2, caractérisé en ce que la couche isolante (12) est formée par un verre de silice, le matériau conducteur de remplissage (18), (27, 28) par du tungstène ou un alliage riche en tungstène, et la couche de séparation (13) est réalisée en nitrure de silicium.

4. Procédé selon la revendication 2, caractérisé en ce que la couche de séparation (13) est choisie d'une nature telle que le matériau conducteur de remplissage (18), (27, 28) puisse être décapé sélectivement par rapport à la couche de séparation, laquelle est utilisée comme couche d'arrêt de décapage lors de l'étape correspondante du procédé (étape e).

5. Procédé selon la revendication 4, caractérisé en ce que lors de la gravure des ouvertures de contact (16b, 16c) (étape c), on met en oeuvre la sélectivité de décapage de la couche de séparation (13) qui est utilisée en tant que masque additionnel pour la gravure dans la couche isolante (12).

6. Procédé selon la revendication 5, caractérisé en ce que le matériau conducteur de remplissage (18), (27, 28) étant formé par du tungstène ou un alliage riche en tungstène, la couche de séparation (13) est réalisée en l'un des métaux : aluminium, alliage d'aluminium ou cobalt.

## Claims

1. A method of manufacturing a configuration of interconnections on a semiconductor device, particularly an integrated circuit, which method comprises the following steps:
a) forming an insulating layer (12) on a substrate (10), on which the elements of the device are provided,
b) covering the insulating layer (12) with a separation layer (13) of such a kind that the latter can be selectively etched with respect to the insulating layer (12),
c) etching narrow contact openings (16b, 16c) through the separation layer (13) and the insulating layer (12),
d) depositing at least one layer of conductive material (18), (27, 28) by a method which ensures a good coverage of the surface, inclusive of the inner surfaces of the contact openings (16b, 16c), the total thickness of this layer being sufficient for filling the volumes of the contact openings,
e) etching away the major portion of the conductive material (18), (27, 28) so as to expose the surface of the separation layer (13) while maintaining said material (18a), (27a, 28a) in the contact openings,
f) selectively removing the separation layer (13),
g) depositing a metal interconnecting layer (22) and etching it into the desired configuration.

2. A method as claimed in Claim 1, characterized in that the separation layer (13) is chosen so that it can be eliminated selectively with respect to the conductive filling material (18), (27, 28).

3. A method as claimed in Claim 2, characterized in that the insulating layer (12) is formed from a silica glass, the conductive filling material (18), (27, 28) is tungsten or an alloy rich in tungsten, and the separation layer (13) is made of silicon nitride.

4. A method as claimed in Claim 2, characterized in that the separation layer (13) is chosen to be of such a kind that the conductive filling material (18), (27, 28) can be etched selectively with respect to the separation layer, which is used as an etching stopper layer during the corresponding step of the method (step e).

5. A method as claimed in Claim 4, characterized in that during the step of etching the contact openings (16b, 16c) (step c) the etching selectivity of the separation layer (13) is utilized, this layer being used as an additional mask for etching the insulating layer (12).

6. A method as claimed in Claim 5, characterized in that, the conductive filling material being tungsten or an alloy rich in tungsten, the separation layer (19) is formed from one of the metals: aluminium, an aluminium alloy, or cobalt.

## Patentansprüche

1. Verfahren zur Herstellung eines Verdrahtungsmusters auf einer Halbleiteranordnung, insbesondere auf einem integrierten Schaltkreis, wobei das Verfahren die folgenden Schritte enthält:
a) Herstellen einer Isolierschicht (12) auf einem Substrat (10), auf dem die Elemente der Anordnung angebracht sind;
b) Bedecken der Isolierschicht (12) mit einer sogenannten Trennschicht (13) dergestalt, daß diese Trennschicht selektiv in bezug auf die Isolierschicht (12) abgeätzt werden kann;
c) Ätzen von schmalen Kontaktlöchern (16a, 16c) durch die Trennschicht (13) und die Isolierschicht (12) hindurch;
d) Aufbringen mindestens einer Schicht aus einem leitfähigen Material (18), (27, 28) nach einem Verfahren, das eine gute Oberflächenbedeckung gewährleistet, einschließlich der Innenflächen der Kontaktlöcher (16b, 16c), wobei die Gesamtdicke der Schicht ausreicht, die Kontaktlöcher vollständig aufzufüllen;
e) Wegätzen des größten Teils des leitfähigen Materials (18), (27, 28), um die Oberfläche der Trennschicht (13) freizulegen, wobei dieses Material (18a) (27a, 28a) jedoch in den Kontaktlöchern erhalten bleibt;
f) selektives Entfernen der Trennschicht (13);
g) Aufbringen einer metallischen Verdrahtungsschicht (22) und Ätzen dieser Schicht in die Form des gewünschten Musters.

2. Verfahren nach Anspruch 1, dadurch gekennzeichnet, daß die Trennschicht (13) so gewählt wird, daß sie selektiv in bezug auf das leitfähige Füllmaterial (18), (27, 28) entfernt werden kann.

3. Verfahren nach Anspruch 2, dadurch gekennzeichnet, daß die Isolierschicht (12) aus einem Silikatglas besteht, das leitfähige Füllmaterial (18), (27, 28) aus Wolfram oder aus einer stark wolframhaltigen Legierung, und die Trennschicht (13) aus Siliziumnitrid.

4. Verfahren nach Anspruch 2, dadurch gekennzeichnet, daß die Trennschicht (13) so gewählt wird, daß das leitfähige Füllmaterial (18), (27, 28) selektiv in bezug auf diese Trennschicht abgeätzt werden kann, die ihrerseits beim entsprechenden Schritt des Verfahrens (Schritt e) als Ätzstopschicht dient.

5. Verfahren nach Anspruch 4, dadurch gekennzeichnet, daß beim Ätzen der Kontaktlöcher (16b, 16c) (Schritt c) die Selektivität des Ätzens der Trennschicht (13) genutzt wird, wobei diese Schicht als zusätzliche Maske für das Ätzen der Isolierschicht (12) verwendet wird.

6. Verfahren nach Anspruch 5, dadurch gekennzeichnet, daß, während das leitfähige Füllmaterial (18), (27, 28) aus Wolfram oder aus einer stark wolframhaltigen Legierung besteht, die Trennschicht aus einem der folgenden Metalle hergestellt ist: Aluminium, Aluminium-Legierung oder Kobalt.
